# EUROPEAN PATENT SPECIFICATION

(11) **EP 1 169 489 B1**
(45) Date of publication and mention of the grant of the patent: **27.11.2002**
(21) Application number: 00922851.1
(22) Date of filing: 11.04.2000
(51) Int. Cl.: C23C 14/56, F04B 37/04

(54) **METHOD FOR INCREASING THE YIELD IN PROCESSES OF DEPOSITION OF THIN LAYERS ONTO A SUBSTRATE**
VERFAHREN ZUR ERHÖHUNG DER AUSBEUTE BEI VERFAHREN ZUR ABSCHEIDUNG VON DÜNNEN SCHICHTEN AUF EINEM SUBSTRAT
PROCEDE POUR L'AUGMANTATION DE L'EFFICACITE DE PROCEDES POUR FORMER DES COUCHES MINCES SUR UN SUBSTRAT

(30) Priority: 12.04.1999 IT MI990744
(43) Date of publication of application: 09.01.2002
(73) Proprietor: SAES GETTERS S.p.A., 20020 Lainate (Milano) (IT)
(72) Inventor: CONTE, Andrea, I-20154 Milano (IT); MAZZA, Francesco, I-20135 Milano (IT); MORAJA, Marco, I-20161 Milano (IT)
(74) Representative: Adorno, Silvano
(86) International application number: PCT/IT00/00136
(87) International publication number: WO 00/061832

(56) References cited:
- EP-A- 0 511 733
- WO-A-94/02957
- US-A- 5 320 496
- US-A- 5 879 134

## Description

The present invention is related to a method for increasing the yield in processes of deposition of thin layers onto a substrate.

Processes for depositing thin layers onto a substrate are widely applied in various industrial branches. For example on these processes is based the production of integrated electronic circuits (also known in this field as ICs); of the supports for storing information, such as the CDs (wherein a thin layer of aluminum is deposited onto a substrate of transparent plastics) or the hard-disks for computers (wherein a magnetic material is deposited onto a support, generally of aluminum); of the flat displays; finally the processes for depositing thin layers are adopted in the developing field of micromechanical devices, being manufactured with techniques quite similar to those utilized in manufacturing ICs.

The main industrial processes of deposition of thin layers are the chemical deposition from vapour phase and physical deposition from vapour phase, better known in the field as "chemical vapour deposition" and "physical vapour deposition" respectively or by their acronyms "CVD" and "PVD".

In the CVD processes, two or more gaseous species are caused to react in an evacuated chamber in which there is a substrate; in the reaction a solid product is formed which deposits onto the substrate in the form of a thin layer. The pressure at which the chamber must be evacuated may be sensibly different in various CVD processes; some of them (being defined of the low-pressure or ultra-high vacuum type) may require initial evacuations of the chamber to pressure values of 10⁻⁸ - 10⁻⁹ mbar; in the following the indication of CVD processes will be always referred to these latter.

With the abbreviated name PVD a series of possible alternative techniques are actually indicated. However all these techniques show the following common features:
- to obtain the thin layer a target of the material that is intended to be deposited is used, having generally the shape of a short-height cylinder, which is positioned in the chamber in front of the substrate and parallel thereto;
- the chamber is firstly evacuated and thereafter filled with an atmosphere of a noble gas, generally argon, at a pressure of 10⁻² - 10⁻⁵ mbar; by applying a potential difference of some thousands volts between the supports of the substrate and of the target (so that the latter will have a cathodic potential), a plasma of electrons and ions Ar⁺ is generated in the space between substrate and target; these ions are accelerated by the electric field towards the target, thus causing its erosion by impact; the species (generally atoms or "clusters" of atoms) resulting from the target erosion will deposit onto the substrate (as well as the other available surfaces) thus forming the thin layer.

Each process may comprise a number of steps of deposition of thin layers, and there are also hybrid processes, comprising both CVD and PVD steps.

It is known that the properties of the thin layer devices, particularly in the case of ICs, are strongly dependent on the presence of defects within the deposited layers. These defects are mainly due to the presence of atoms of chemical species different from those which form the layer. Consequently it is necessary to reduce to a minimum the possible pollution sources in all steps of the process, by using reactants of the maximum possible purity (reactive gases in case of CVD and the target in case of PVD) and ensuring the highest cleanness of all the surfaces in the process chamber and of the process atmosphere.

Furthermore, even if it is possible to carry out the deposition at the same time onto several substrates (in both cases of CVD and PVD) the industrial trend is in the direction of processes with a single substrate which allow a better control of the deposit features.

To meet the above-mentioned requirements, the processes of deposition of thin layers are performed in systems comprising at least one chamber, but generally a plurality of chambers, each of which being designed for a specific operation; for example there are actual process chambers wherein the deposition steps are carried out, or conditioning chambers, being employed e.g. for cleaning or heating the substrates before the deposition. In the following, the process and conditioning chambers will be generally indicated as treatment chambers. In case of several treatment chambers, these can be positioned in line, directly connected to one another; alternatively, these chambers can be positioned around a central transferring chamber. Each chamber is connected with the contiguous ones by means of valves which are normally closed and are opened only to allow the transfer of the substrates from a chamber to the other during the various steps of the process.

In order to guarantee the highest cleanness possible, in general all the chambers are kept under vacuum, with the best values of vacuum in the deposition chambers. The substrates are handled from a chamber to the subsequent ones through automated means, in general mechanical arms. In a simple operational example of a process system (of the type comprising chambers positioned around a transfer chamber), the substrates are introduced into a first chamber at the inside of suitably shaped boxes, the inner walls of which are provided with tangs whose purpose is that of keeping the substrates separate from each other in order to simplify the automated handling operations. A vacuum of about 10⁻⁵ - 10⁻⁶ mbar is made in this first chamber and a first valve is opened to communicate this chamber with a transfer chamber; a mechanical arm takes a substrate from the box and carries it to the transfer chamber, where the pressure is at lower levels than in the first chamber, generally of about 10⁻⁷ mbar, and the first valve is closed; a second valve is then opened for communicating the transfer chamber to a process chamber, the substrate is brought to the position at which the deposition will take place and the process chamber is closed by closing the second valve. Upon completion of deposition of the thin layer, the substrate can then be transferred, again by means of mechanical arms and through transfer chambers, to the outside of the system or to another chamber thereof.

Ideally, the systems for depositing thin layers should always be kept isolated from the atmosphere. However the treatment chambers must be periodically opened for operations concerning the maintenance of the automated equipments, the cleanness of inner surfaces or, in case of PVD, for replacing the target when this is exhausted or a different material has to be deposited. At each opening the chamber is brought to ambient pressure and its inner walls, the surfaces of the equipments and of the target adsorb the atmospheric gases, in particular water vapour. These gases are then released into the chamber during the manufacturing steps. During manufacturing, a continuous pumping is maintained in the chambers so as to remove impurities therefrom, and particularly the atmospheric gases released by surfaces as described above. The balance between the degassing flow from the surfaces and the gas removal speed of the pumps during the manufacturing processes is determinant for the basic pressure of the system; the lower this basic pressure, the lower the amount of possible contaminants for layers under deposition. Typically, in order to improve the basic pressure, after each opening the chambers are caused to undergo a pumping under heating at temperatures of about 100-300°C (this step is known in the field as "baking"). This treatment has the purpose of increasing the degassing of all the surfaces in the chamber and removing as much as possible of the gases initially adsorbed on these surfaces; the higher is the pumping speed during the baking step, the more efficient is such a removal. In this way the residual quantity of adsorbed gases is reduced and, consequently, the degassing flow during the manufacturing steps; with the pumping speed being the same during manufacturing, a lower basic pressure of the chamber is obtained and consequently a lower quantity of impurities in the process atmosphere. After baking the evacuation is caused to go on; the chamber cleanness is considered acceptable for starting a new cycle of depositions when the pressure reaches a preset value, generally comprised between about 10⁻⁷ and 10⁻⁹ mbar. The surface of target used in PVD processes is cleaned by a treatment in which the same deposition step as in the manufacturing process is carried out on a dummy substrate that is then discharged; this conditioning step of the target is known in the field with the definition "burn-in".

With the present technology, the pumping step for bringing back the chamber pressure from about 1000 to about 10⁻⁸ mbar, requires a time varying between about 4 and 12 hours; for the burn-in step a time varying between half an hour and 4 hours is required. These two preparatory steps are necessary to obtain devices of high quality, but they involve dead times as to productivity.

Another possible source of contamination of the deposition chambers is the repeated opening of these for the transfer of substrates. As said above, the transfer chambers are normally maintained at pressures higher than the treatment chambers, and in turn, chambers with the boxes holding substrates are kept at pressures higher than the the transfer chambers. Whenever valves communicating chambers are opened, there's a transfer of gases from the higher pressure to the lower pressure chamber, resulting in a continuous transfer of contaminant gases from the substrate boxes chambers to the treatment chambers. Moreover, the surface of the substrates themselves is generally "dirty", having atmospheric gases adsorbed thereon; these gases are released in the low-pressure environment of the treatment chambers.

According to the above, there is a number of possible sources of contamination of thin layers under formation, that can lead to production wastes. The yield of devices produced by using techniques of thin layer deposition can be increased either reducing pump-down times of chambers or reducing overall contamination of the working atmosphere, or better, by acting on both these process features.

It is an object of the present invention to provide a method according to claim 1 for increasing the yield in the processes of depositing thin layers onto a substrate.

These objects are achieved according to the present invention, which in a first aspect thereof deals with a method for increasing the yield of processes for depositing thin layers, comprising contacting a getter device in activated form with the working atmosphere within a process chamber when the sum of partial pressures of reactive gases in the chamber is lower than about 10⁻³ mbar, and when no actual production substrate is being processed, by using the automated substrate handling equipments and procedures used in the manufacturing steps.

The above indicated reactive gases are those gases, well-known in the gettering art, towards which getter materials are highly reactive; these gases mainly include oxygen, water, carbon dioxide, carbon monoxide, hydrogen and in some cases nitrogen. As is known, getter materials require for their operation an activation heating treatment at temperatures between about 250 and 900°C and during a time comprised between few minutes and about an hour, according to the chemical composition of the specific material. In case an activated getter device is exposed to an atmosphere where the sum of partial pressures of reactive gasses is higher than about 10⁻³ mbar, violent reactions can take place, potentially dangerous for the equipments present in the chamber. On the other hand, getter materials are totally inert to noble gasses, that are normally employed as the working atmosphere in the processes of deposition of thin layers. So, as will be described in the following, the method of the invention foresees the possibility that a getter device is present in activated form in the treatment chamber when the total pressure therein is well above 10⁻³ mbar, provided this is the maximum pressure obtained by summing up the partial pressure of the above defined reactive gases.

The invention will be described in the following in some of its embodiments with reference to the drawings wherein:
- Figures 1-4 show, as flow-charts, some possible alternative embodiments of the method according to the invention;
- Figures 5-7 show some possible embodiments of getter devices according to the invention;
- Figure 8 shows two curves representing the pressure in a PVD chamber during its evacuation, recorded respectively according to known procedures and according to the method of the invention.

The use of getter materials and devices at the inside of thin layers depositing chambers has been already disclosed in the patent application EP-A-693626, the publications of international patent application WO 96/13620 and WO 97/17542 and in US Pat. No. 5.778.682. However, all these documents describe getter systems which remain in the chamber also during the manufacturing process. For instance, document WO 96/13620 describes a semiconductor processing chamber inside which it is disposed a getter pump made up of a plurality of getter disks stacked on a central support that may also have the function of heater for the getter disks. This pump is permanently fixed in the chamber in a position away from the position where the semiconductor wafer is processed, such as in a comer on the bottom wall of the chamber. The method of the invention is different from the use of getter systems according to these documents, since these latter require substantial modifications of the configuration of the process chambers, in particular to provide suitable heating means for activating and operating the getter materials. The European patent application EP-A-926258, in the name of the applicant, discloses a further utilization of getter systems in PVD processes; however, in this case too, the getter system is kept in the chamber during the process.

The presence of an activated getter device in a treatment chamber according to the invention can help both in increasing evacuation speed thereof and in reducing overall contamination, thus contributing in different ways to the production yield.

These results can be accomplished by the use of getter devices in a number of ways.

In a first possible embodiment of the method of the invention, a non-activated getter device is introduced in an open chamber, on the substrate holder; the chamber is then closed and its evacuation is begun. As soon as pressure has reached a value of about 10⁻³ mbar, the getter device previously introduced in the chamber is thermally activated, for instance by using the heating means in the substrate holder. At the same time, the flushing of the chamber with a noble gas such as argon, and possibly the baking procedure, are started; the pumps connected to the chambers are always working during these operations. Flushing with argon is continued until the level of contaminants is below a give value, as can be checked with sensors or analyzers, such as a mass-spectrometer, connected to the chamber. In alternative, and upon calibration of the evacuation chamber parameters, flushing with argon can be continued for a given time. When the contamination level is suitable for production, the getter device is removed from the chamber and a new production run is started. At this point, the chamber is already filled with argon, the process medium. According to this procedure, the pressure in the chamber never goes down to 10⁻⁷ mbar or lower, and removal of contaminants from the chamber atmosphere is performed by the washing action of the flushing noble gas in cooperation with the activated getter device.

As an alternative, the same process above can be carried out by closing the chamber and starting its evacuation with no getter device present. In this case, a pre-activated getter device is introduced in the chamber (not necessarily on the substrate holder) from a transfer chamber by means of the mechanical arms.

The getter devices of the invention can also be re-introduced and perform their function at fixed times during process operations, for instance to help reducing contamination introduced by repeated openings of the chamber valves or by outgassing of the surface of substrates. According to this possible application of the method of the invention, a getter device is introduced into the chamber at fixed times. In this case a step of cleaning of the process chamber atmosphere can be provided for after a given number of substrates have been processed; for instance, this can be done after all substrates in a box have been processed, and before the use of substrates of a new box. To this end, it is sufficient to transfer in the treatment chamber a getter device of the invention (pre-activated or to be activated) in place of a production substrate, and between the processing of two such substrates.

As said above, a new production run could be started after a chamber opening without previously reaching pressures in chamber of 10⁻⁷ mbar or lower. However, reaching very low pressures in the chamber before a new production run is the most common procedure adopted in the industry. In this case, the method of the invention is particularly useful in reducing the time required for bringing a chamber back to its operational condition after any opening, with the getter devices contributing to eliminating the atmospheric gases. In the following description, by "pressure necessary to begin the production" it is meant a pressure of 10⁻⁷ mbar or lower.

According to this preferred way of implementation, the method of the invention comprises the steps of:
- introducing a getter device into the treatment chamber after its opening, before or during its evacuation, operating so that the getter device is present in the chamber in activated form only when the pressure therein has reached values of 10⁻³ mbar or less;
- continuing the chamber evacuation while maintaining therein the getter device activated until reaching the pressure necessary for starting the manufacturing process; and
- removing the getter device from the chamber by using the same automated substrate handling equipments and procedures used in the manufacturing steps.

In a variation of the process outlined above, it is possible to keep the getter device in the chamber even upon reaching the pressure necessary to begin the production, when some operations are carried out which are preliminary to the actual manufacturing steps.

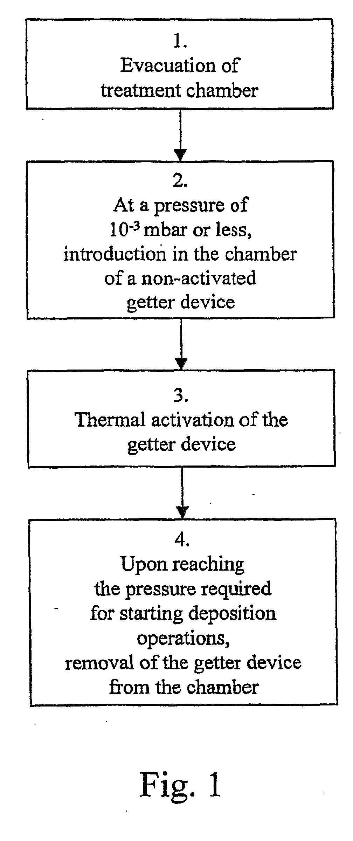

Figures 1-4 represent, in the form of flow-charts, some possible alternative embodiments of the preferred way of implementing the method of the invention.

With reference to figure 1, after each opening of the process chamber, this is closed again and its evacuation starts (step 1); for the evacuation low-vacuum mechanical pumps (e.g. rotary pumps) are generally used at the beginning and subsequently, when the pressure in the chamber is at values of about 1-10⁻² mbar, medium and high-vacuum pumps are used, such as turbomolecular or cryogenic pumps. When the pressure has reached values of 10⁻³ mbar or less and still under pumping, the getter device is taken from the box and brought into the process chamber (step 2) by means of the same automated substrate handling equipments and procedures used in the manufacturing steps; the getter device is thus positioned in the same zone, in the following defined as deposit zone, usually occupied by the substrates during the manufacturing of thin layers. This is generally formed of a substrate-holder supported by a possibly movable pedestal that locates the substrate at about the chamber center. The possibility of heating the deposit zone is generally provided in the thin layer deposit chamber: in fact the substrate heating during the manufacturing steps allows to obtain more homogeneous thin layers; furthermore, during the initial steps of evacuation it is necessary that the pedestal can be heated to allow its degassing. To this purpose heating means are provided in the pedestal such as electrical resistors, or infra-red lamps that heat the deposit zone either from the inside or from the outside of the chamber, through quartz windows.

The getter device, positioned in the deposit zone, is subjected to a thermal activation treatment (step 3) at temperatures comprised between about 300 and 700°C during a time comprised between about ten minutes and one hour according to the getter material employed, by the means provided for the heating of the substrate.

The thus activated getter device increases the speed of the subsequent pumping of the chamber until the pressure required for starting the manufacturing process, generally of about 10⁻⁸ mbar, and improves the base pressure of the system due to the residual degassing of the walls.

The getter device is then removed from the chamber (step 4), by using handling means and procedures as adopted in manufacturing for transportation of the substrates, and the manufacturing process is caused to start by introducing the manufacturing substrates into the chamber.

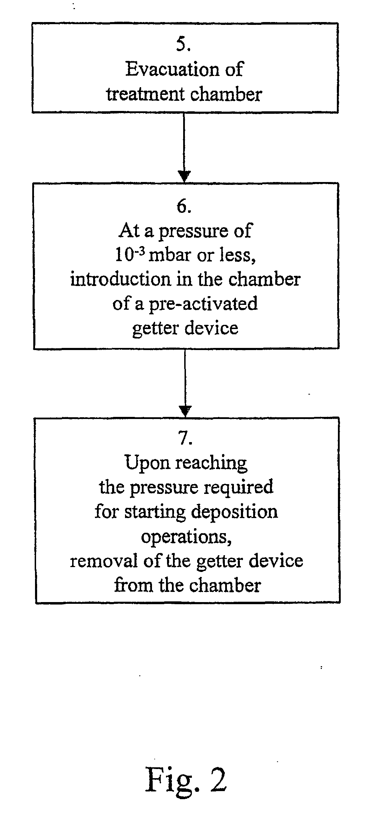

Figure 2 shows a possible alternative way of carrying out the method of the invention. After starting of evacuation (step 5), upon reaching the pressure of 10⁻³ mbar, a pre-activated getter device is introduced into the process chamber (step 6); the device can for example be activated in another treatment chamber, such as a chamber provided for the pre-heating of the manufacturing substrates. Subsequently, upon reaching the desired pressure for starting the manufacturing steps, the getter device is removed from the chamber (step 7).

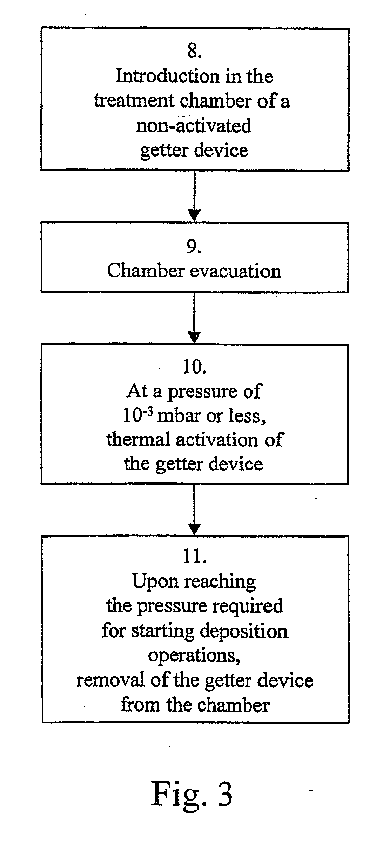

Figure 3 shows another possible alternative embodiment of the method of the invention. In this case the getter device is introduced into the process chamber (step 8) before the beginning of the evacuation step (step 9); in this case, the getter device may be introduced into the chamber immediately after its closure, by making use of the automated handling means of the system or even by hand before such a closure. When the pressure in the process chamber has reached values of 10⁻³ mbar or less, the device is activated by heating at temperatures comprised between about 300 and 700°C by making use of means and procedures adopted in manufacturing for heating the substrates (step 10). Thereafter the evacuation is caused to go on with the activated getter device in the chamber until reaching the desired pressure for the starting of the manufacturing processes, at which pressure the getter device is removed from the chamber (step 11) and the manufacturing process begins.

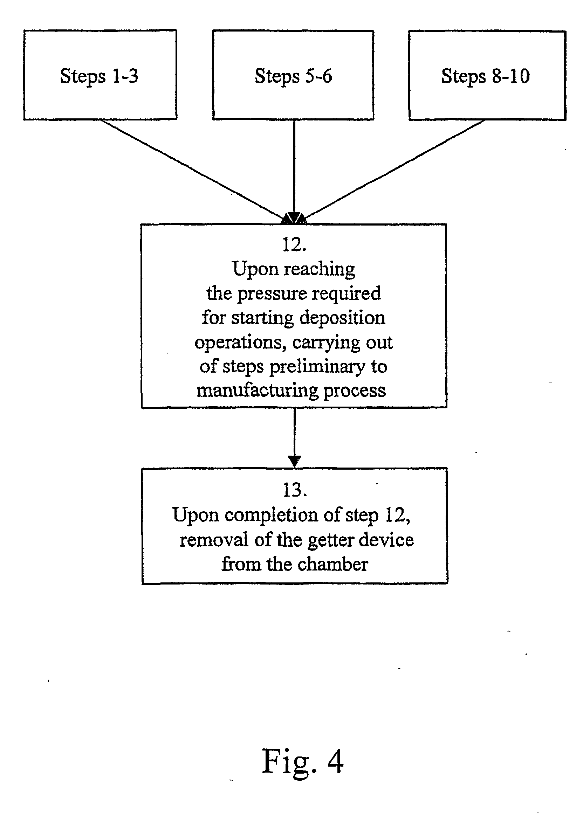

Finally, when the process provides for steps preliminary to the actual manufacturing steps, it is also possible during the first ones to keep the getter device at the inside of the chamber. The possibility is represented in figure 4: according to this embodiment of the method of the invention, the initial steps of any one of the method described with reference to Figs. 1-3 are repeated, but, upon reaching the vacuum level desired, a step (12) preliminary to the manufacturing ones is carried out before removing the getter device from the chamber (step 13). An example of processes of this type is given by PVD processes wherein, upon evacuation of the chamber at pressures of less than about 10⁻⁷-10⁻⁸ mbar, the above-described burn-in step is generally carried out by introducing in the chamber argon at a pressure of 10⁻³ mbar and simulating a manufacturing process. Under these conditions the getter device is coated with the target material and quickly loses its efficiency of gas sorption; on the other hand, the gas sorption action is still present in the first stage of the treatment, thus contributing to keeping the process atmosphere clean, and in any case the presence of the getter device saves a transfer step of a dummy substrate from the box to the chamber.

According to a second aspect thereof, the invention relates to getter devices for carrying out the previously described method.

As said before, the getter devices of the invention are charged in the same boxes of the substrates used in manufacturing and are handled by the same automated equipments which handle said substrates. To this purpose, the getter devices must have essentially the same size of the manufacturing substrates; in fact, getter devices of greater size could not be positioned in the containers and could not pass through the valves which close the transfer chambers, while getter devices of smaller size than the substrates could not be caught by the automated handling equipments. Another reason for using getter devices of the same size as the substrates is that the surface available for the getter material and thereby also the gas sorption properties of the device are thus brought to a maximum. The getter devices of the invention can consequently have a thickness comprised between about 0.5 and 5 mm, and lateral dimensions varying between about 10 and 100 cm; to give some examples, in case of ICs, devices of essentially round shape will be used, with a thickness between about 0.5 and 1 mm and diameter from about 150 to 300 mm, while in case of manufacturing flat displays, the devices are generally rectangular with a thickness between about 1 and 5 mm and lateral size varying between 10 cm and one meter.

The getter devices of the invention can be made of getter material only, e.g. sintered powders. However, considering their particular geometry, with lateral dimensions much greater than the thickness, sintered bodies exclusively made of powders could result in low mechanical resistance giving rise, in consequence of possible breaking, to portions no longer adapted to be handled by the automated equipments and to fragments or powders being present in the process chambers.

In consequence, it is preferable to use getter devices formed of a layer of getter material deposited onto a support, which ensures the necessary mechanical resistance. As support it is possible to use whichever material on which the getter materials have a good adhesion and showing good features of mechanical resistance and of resistance to the conditions that the devices must undergo in the chambers, in particular the activation treatment of the getter material. It is also preferable that the support material does not release large quantity of gas under vacuum at the temperatures reached during activation in order to give no appreciable contribute to the quantity of gases in the chamber. The materials which are the best in meeting these conditions are metals and metallic alloys, e.g. steel, titanium, nickel-chromium alloys, or silicon, ceramic or glass.

The devices formed of getter materials on a support can have the deposit on both faces or a single one of them. In some thin layer depositing processes, the substrates are handled in a vertical position within the system, being only in contact with a guide by which they are supported through an edge portion and having both faces essentially free: an example is the manufacturing of hard disks for computers which are coated with magnetic material for storing information on both faces. In this case it is preferable to use devices with getter material deposited on both faces, what allows to render maximum the surface of active material. In case instead that the use is intended in chambers wherein the substrate is treated in horizontal position, with a face resting on a sample holder, the devices to be used have preferably the getter material deposit on a single face only; in fact in this configuration a possible deposit of getter material on the face in contact with the sample holder would involve the possibility of particles losses thereon without however contributing to the gas removal. Examples of processes adopting this substrate configuration are the manufacturing of ICs and of CD.

In both cases it could also be preferable that the support surface is not completely coated with the getter material, but that at least a portion of the support edge is left free of the deposit. This prevents the possibility that the getter device may lose particles by rubbing either when it is in the substrate box, wherein it is kept in vertical position by suitable tangs, or when it is handled by the automated means provided in the process chamber, which can comprise clamps holding the substrates by their edge.

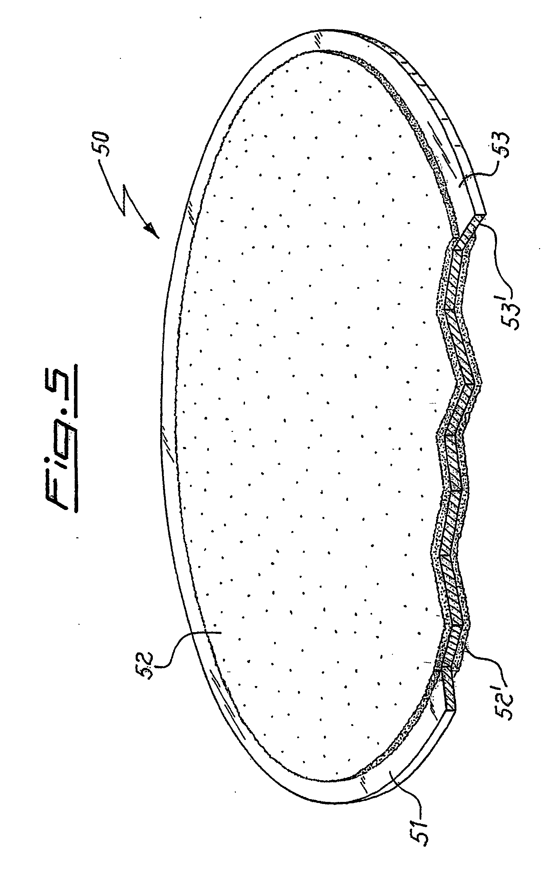

Figures 5-7 reports some examples of possible getter devices of the invention.

The figure 5 shows in a cut-away representation a getter device 50 suitable for use in systems for manufacturing hard-disks of computers. The device consists of a support 51 of circular shape, coated on both faces with deposits 52, 52' of getter material; the deposits 52, 52' do not completely coat the support faces, but leave two free areas, 53 and 53', corresponding to the support edge on both faces. A device of this type is handled in vertical position in a process system by means of automated systems ending with clamps holding the device at the edge.

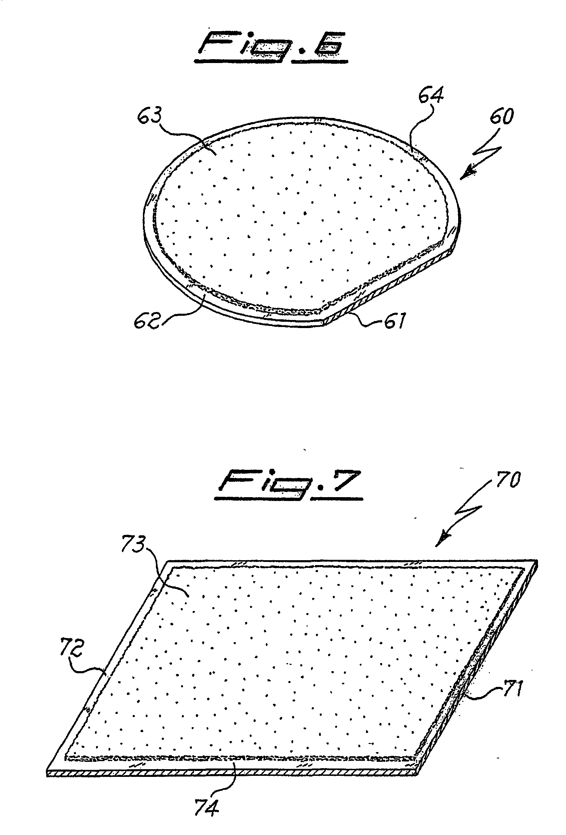

Figure 6 represents a getter device (60) suitable for use in the systems for manufacturing of integrated circuits. There is exemplified the case in which, as support 61, a manufacturing substrate is used, being formed as a "slice" of monocrystalline silicon; these substrates have an essentially circular shape except for a portion subtended by an arc, which allows to recognize and keep constant the orientation of the substrate in the process system. The deposit 63 of getter material is present on one face only, 62, of support 61; the deposit leaves clear an edge 64 of face 62 for the purposes described above.

Finally, figure 7 shows a getter device 70 to be used in the system for manufacturing flat displays. The device consists of a support 71 coated on one face only, 72, with a deposit 73 of getter material that leaves uncoated an edge 74 of the support.

The getter materials that can be used for the production of the devices according to the invention are various and comprise e.g. metals such as Zr, Ti, Nb, Ta, V; the alloys among these metals or of them with one or more other elements chosen among Cr, Mn, Fe, Co, Ni, Al, Y, La and rare-earths, such as the binary alloys Ti-V, Zr-V, Zr-Fe and Zr-Ni or ternary alloys Zr-Mn-Fe or Zr-V-Fe; and mixtures of metals with the previously indicated alloys. Getter materials suitable to the purposes are the alloy manufactured and sold by applicant under the name St 787 and having the percent composition by weight Zr 80,8% - Co 14,2% - A 5%, where with A it is meant any element chosen among yttrium, lanthanum, rare earths or mixtures thereof; the alloy of percent composition by weight Zr 84% - Al 16% manufactured and sold by the applicant under the name St 101® ; the alloy of percent composition by weight Zr 70%-V 24,6% - Fe 5,4% manufactured and sold by the applicant under the name St 707; or mechanical mixtures of the two last cited alloys with metals Zr or Ti; these mixtures are preferable, thanks to their good mechanical characteristics, particularly in respect to particle loss. Particularly suitable for the purposes of the invention are the devices obtained through the mixture manufactured and sold by the applicant under the name St 121, formed by 70% by weight of powders of titanium and by 30% by weight of powders of alloy St 101®.

Getter devices formed as a getter material layer on a support can be obtained following various different techniques. A first possibility is that of depositing the layer onto the support with the PVD technique. The preparation of getter devices with the PVD technique is described for example in the publication of international patent application WO 97/49109. This technique provides the advantage of allowing the deposition of getter material onto many kinds of supports, glass and ceramics included; moreover, deposits obtained through the PVD technique do not present the possible drawback of possible lose of particles. Other techniques consist in depositing onto a support the getter material in form of powders. The deposition of powders can be carried out by cold rolling; this technique is widely known in the field of the powders technology, but can be adopted only with metallic supports. Another possibility is spraying a suspension of getter particles in a suitable solvent onto the support kept hot, as described in the patent application WO 95/23425 to which reference is made for the details of this technique. Furthermore the support may be coated with particles of getter material by the electrophoretic technique. In this case it is required that the support is electrically conducting: for the details of this technique reference is made to the US Pat. No. 5,242,559. Finally, the deposition of powders of getter material onto the support can be carried out by the serigraphic technique, as described in the publication of international patent application WO 98/03987. The serigraphic technique is particularly convenient, since it allows to deposit getter material onto supports of different nature (metals, silicon, glass, ) and to obtain shaped deposits, thus rendering easier, for instance, the manufacturing of the getter devices exemplified in the figures 4-6, where a portion of the support surface is free of deposit.

The invention will be further illustrated by means of the following examples. These non-limiting examples show some embodiments designed to teach those skilled in the art how to practice the invention and to represent the best considered mode for putting into practice the invention.

### EXAMPLE 1 (COMPARATIVE)

This example is representative of a known evacuation procedure of a process chamber. A standard PVD chamber evacuation run is performed, monitoring pressure variations throughout the run. The chamber comprises a pedestal supporting a sample-holder which, in turn, comprises heating means in the form of an internal electrical resistance. The chamber comprises, as further internal heating means, two quartz lamps located on two opposed side walls. For evacuation, the chamber is ported to a pump-down group comprising a rotary pump and a cryogenic pump. At pressures below 10⁻⁵ mbar, pressure in chamber is measured by a Bayard-Alpert manometer.

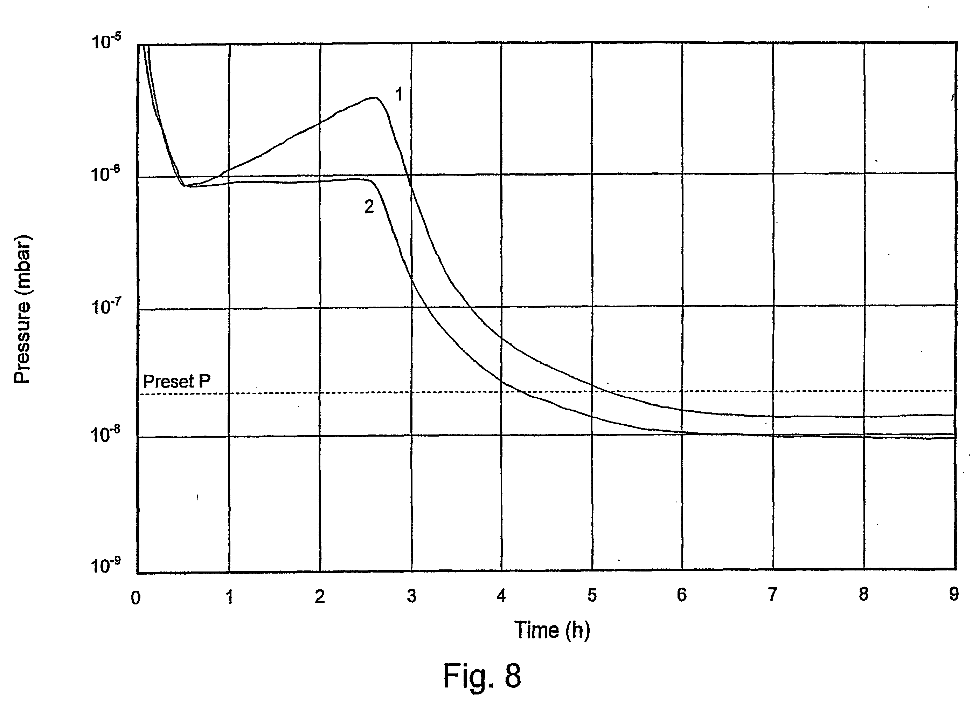

At the beginning of the test the chamber is closed, and pumping is started. When pressure in the chamber reaches a value of about 10⁻⁶ mbar, the baking procedure is begun, heating the interior of the chamber by turning on the quartz lamps and the heater provided inside the sample-holder, that is brought to 500 °C; as discussed before, this procedure has the function of causing release of gases, mainly H₂O, adsorbed onto all surfaces inside the chamber, so as to remove these to the maximum possible extent during the pump-down step, and avoid that the same are subsequently released in the chamber atmosphere during manufacture. Baking lasts 2 hours. At the end of the baking procedure, heating is turned off, and the chamber is allowed to cool down, always under pumping. The values of pressure measured in chamber during the test are reported in Fig. 8 as curve 1.

### EXAMPLE 2

This example is representative of a preferred way of implementation of the method of the invention. In particular, this example is an embodiment of the method described with reference to Fig. 3. It is provided a non-activated getter device consisting of a silicon wafer of diameter about 200 mm, on a face of which is deposited by screen printing a layer (thickness 150 µm) of the St 121 getter material described above. The getter device is placed onto the sample-holder of the chamber. The evacuation procedure depicted in example 1 is then repeated. During the baking procedure, the sample holder brings the temperature of the getter device at about 500 °C, thus activating the getter material. The values of pressure measured in chamber during the test are reported in Fig. 8 as curve 2.

As can be easily seen by the comparison of curves 1 and 2 in Fig. 8, the use of a getter device according to the method of the invention helps getting rid of the amount of gases released by all surfaces present inside the chamber (chamber walls and surfaces of any parts and devices present in the chamber). In particular, curves in Fig. 8 show a pressure increases in test 1, due to the balance of the speed of gasses release from surfaces and speed of gasses removal from the pumping group; a similar pressure increase is not seen in the test according to the invention, as in this case the getter device contributes to overall gas sorption. At the end of baking, the pressure in the chamber is lower in the invention test than it is in the test according to the prior art; similarly, the method of the invention allows reaching values of final pressure lower than with the test run according to prior techniques. Looking at things from another standpoint, possibly even more interesting for the semiconductor industry, the invention offers the relevant advantage that it allows reaching a given base pressure (e.g., a preset value of pressure at which a new production run can be started) in shorter time. This is shown by the dotted line (indicated as Preset P) in Fig. 8: a pressure value of about 2 x 10⁻⁸ mbar is reached in little more than 4 hours with the method of the invention, and in more than 5 hours with normal procedures.

The method of the invention can be easily implemented in all the known deposition processes, as it uses for transferring the getter devices the same handling means used for moving the manufacturing substrates into and out from the treatment chambers, while for activating the getter devices it employs the same substrate heating means already normally present in the chamber; therefore the method does not require that additional suitable equipments are made available. In addition, the accomplishment of the method is carried out during the usual preparatory steps of the manufacturing processes, thus not requiring substantial modifications and in particular prolongation of these steps.

## Claims

1. Method for increasing the yield of the processes of deposition of thin layers onto a substrate, comprising contacting a getter device in activated form with the working atmosphere within a process chamber when the sum of partial pressures of reactive gases in the chamber is lower than about 10⁻³ mbar, and when no actual production substrate is being processed, by using the automated substrate handling equipments and procedures used in the manufacturing steps at least for removing the getter device from the processing chamber while the latter being maintained under vacuum or at the pressure required for said process of deposition.

2. Method according to claim 1, wherein the getter is exposed to the process chamber atmosphere when the total pressure in said chamber is higher than 10⁻³ mbar and said atmosphere mainly comprises noble gases.

3. Method according to claim 2, comprising the step of:
- starting evacuation of a process chamber;
- when the pressure has reached a value of about 10⁻³ or lower, introducing in the chamber a pre-activated getter device or, alternatively, thermally activating a getter device previously introduced in the chamber;
- flushing the chamber with the same noble gas that will be used as the process atmosphere;
- when the level of contaminants in the chamber atmosphere is below a given value, starting the deposition procedures.

4. Method according to claim 1, wherein a getter device is re-introduced in the process chamber and caused to perform its gettering function at fixed times during process operations.

5. Method according to claim 4, wherein a getter device is re-introduced in the process chamber after all the substrates in a box have been processed and before starting processing the substrates of a new box.

6. Method according to claim 1, comprising the steps of:
- introducing a getter device into the process chamber (2; 6; 8) after its opening, before or during the evacuation thereof (1; 5; 9), while operating in such a way that the getter device is present in an activated form in the chamber only when the pressure therein has reached values of 10⁻³ mbar or less;
- continuing the evacuation in said chamber, while keeping therein the activated getter device; and
- when the pressure in said chamber has reached a value of 10⁻⁷ mbar or lower, removing the getter device from said chamber (4; 7; 11) by using the automated substrate handling equipments and procedures used in the manufacturing steps.

7. Method according to claim 6 comprising the steps of:
- starting the evacuation (1) of the process chamber;
- upon reaching a pressure value in said chamber of 10⁻³ mbar or less, introducing (2) a getter device in a non-active form by means of the automated substrate handling equipments and procedures used during the manufacturing steps;
- activating (3) the getter device in said chamber by means of the equipments and procedures as used for heating the substrates during the manufacturing steps;
- when the pressure in said chamber has reached a value of 10⁻⁷ mbar or lower, removing (4) the getter device from the chamber by means of the automated substrate handling equipments and procedures used for moving the substrates during the manufacturing steps.

8. Method according to claim 6 comprising the steps of:
- starting the evacuation (5) of the process chamber;
- upon reaching in said chamber a pressure value of 10⁻³ mbar or less, introducing into said chamber (6) a getter device, pre-activated in a different chamber of the system, by means of the automated substrate handling equipments and procedures used for moving the substrates during the manufacturing steps;
- when the pressure in said chamber has reached a value of 10⁻⁷ mbar or lower, removing (7) the getter device from the chamber by means of the automated substrate handling equipments and procedures used for moving the substrates during the manufacturing steps.

9. Method according to claim 6 comprising the steps of:
- introducing (8) into the process chamber a getter device in a non-activated form;
- starting the evacuation (9) of said chamber;
- upon Teaching in said chamber a pressure value of 10⁻³ mbar or less, thermally activating (10) the getter device by the means and procedures as used during manufacturing for heating the substrates;
- when the pressure in said chamber has reached a value of 10⁻⁷ mbar or lower, removing (11) the getter device from chamber by means of the automated substrate handling equipments and procedures used for moving the substrates during the manufacturing steps.

10. Method according to claim 6 wherein, upon reaching a pressure of 10⁻⁷ mbar or lower, the getter device is removed from said chamber (13) only after the carrying out of steps preliminary to deposition of thin layers (12).

11. Method according to claim 10, wherein the deposition process for thin layers is of the PVD type and said preliminary steps comprise the step of cleaning a target.

## Patentansprüche

1. Verfahren zur Steigerung der Ausbeute der Prozesse der Abscheidung von dünnen Schichten auf einem Substrat, das die Berührung einer Gettervorrichtung in aktivierter Form mit der Arbeitsatmosphäre innerhalb einer Prozesskammer umfasst, wenn die Summe der Partialdrücke der Reaktionsgase in der Kammer kleiner als 10⁻³ mbar ist, und wenn kein tatsächliches Produktionssubstrat verarbeitet wird, unter Verwendung der automatischen Substrathandhabungsausrüstungen und -abläufe, die in den Fertigungsschritten mindestens zum Herausnehmen der Gettervorrichtung aus der Prozesskammer verwendet werden, während die letztere unter Vakuum bzw. einem Druck gelassen wird, der für den Prozess der Abscheidung erforderlich ist.

2. Verfahren nach Anspruch 1, wobei der Getter der Atmosphäre der Prozesskammer ausgesetzt ist, wenn der Gesamtdruck in der Kammer größer als 10⁻³ mbar ist, und die Atmosphäre hauptsächlich Edelgase umfasst.

3. Verfahren nach Anspruch 2, umfassend den Schritt:
- des Einschaltens der Evakuierung einer Prozesskammer;
- wenn der Druck einen Wert von ungefähr 10⁻³ oder niedriger erreicht hat, des Einbringens einer voraktivierten Gettervorrichtung in die Kammer oder alternativ der thermischen Aktivierung einer Gettervorrichtung, die vorher in die Kammer eingebracht ist;
- der Spülung der Kammer mit dem gleichen Edelgas, das als Prozessatmosphäre verwendet wird;
- wenn die Stärke der Verunreinigungen in der Kammeratmosphäre unter einem vorgegebenen Wert ist, des Einschaltens der Aufdampfungsabläufe.

4. Verfahren nach Anspruch 1, wobei eine Gettervorrichtung in die Prozesskammer wieder eingebracht und veranlasst wird, seine Getterfunktion zu festgelegten Zeiten während der Prozessschritte durchzuführen.

5. Verfahren nach Anspruch 4, wobei eine Gettervorrichtung in die Prozesskammer wieder eingebracht wird, nachdem alle Substrate in einer Box verarbeitet sind und bevor mit der Verarbeitung der Substrate einer neuen Box begonnen wird.

6. Verfahren nach Anspruch 1, umfassend die Schritte:
- des Einbringens einer Gettervorrichtung in die Prozesskammer (2; 6; 8) nach ihrem Öffnen, vor oder während ihrer Evakuierung (1; 5; 9), während des Betriebes auf solch eine Art, dass die Gettervorrichtung in einer aktivierten Form in der Kammer nur anwesend ist, wenn der Druck darin Werte von 10⁻³ mbar oder kleiner erreicht hat;
- der Fortführung der Evakuierung der Kammer, während darin die aktivierte Gettervorrichtung gelassen wird; und
- wenn der Druck in der Kammer einen Wert von 10⁻⁷ mbar oder niedriger erreicht hat, des Herausnehmens der Gettervorrichtung aus der Kammer (4; 7; 11) unter Verwendung der automatischen Substrathandhabungsausrüstungen und -abläufe, die in den Fertigungsschritten verwendet sind.

7. Verfahren nach Anspruch 6, umfassend die Schritte:
- des Einschaltens der Evakuierung (1) der Prozesskammer;
- nach Erreichen eines Druckwertes in der Kammer von 10⁻³ mbar oder niedriger des Einbringens (2) einer Gettervorrichtung in einer nichtaktiven Form mit Hilfe der automatischen Substrathandhabungsausrüstungen und -abläufe, die während der Fertigungsschritte verwendet sind;
- des Aktivierens (3) der Gettervorrichtung in der Kammer mit Hilfe der Ausrüstungen und Abläufe, wie für die Heizung der Substrate während der Fertigungsschritte verwendet;
- wenn der Druck in der Kammer einen Wert von 10⁻⁷ mbar oder niedriger erreicht hat, des Herausnehmens (4) der Gettervorrichtung aus der Kammer mit Hilfe der automatischen Substrathandhabungsausrüstungen und -abläufe, die für das Bewegen der Substrate während der Fertigungsschritte verwendet sind.

8. Verfahren nach Anspruch 6, umfassend die Schritte:
- des Einschaltens der Evakuierung (5) der Prozesskammer;
- nach Erreichen eines Druckwertes in der Kammer von 10⁻³ mbar oder weniger, des Einbringens einer Gettervorrichtung in die Kammer (6), die in einer anderen Kammer des Systems voraktiviert ist, mit Hilfe der automatischen Substrathandhabungsausrüstungen und -abläufe, die für das Bewegen der Substrate während der Fertigungsschritte verwendet sind;
- wenn der Druck in der Kammer einen Wert von 10⁻⁷ mbar oder niedriger erreicht hat, des Herausnehmens (7) der Gettervorrichtung aus der Kammer mit Hilfe der automatischen Substrathandhabungsausrüstungen und -abläufe, die für das Bewegen der Substrate während der Fertigungsschritte verwendet sind.

9. Verfahren nach Anspruch 6, umfassend die Schritte:
- des Einbringens (8) einer Gettervorrichtung in die Prozesskammer in einer nichtaktivierten Form;
- des Einschaltens der Evakuierung (9) der Kammer;
- nach Erreichen eines Druckwertes in der Kammer von 10⁻³ mbar oder weniger, der thermischen Aktivierung (10) einer Gettervorrichtung mit Hilfe der Vorrichtungen und Abläufe, die während der Fertigung für das Heizen der Substrate verwendet sind;
- wenn der Druck in der Kammer einen Wert von 10⁻⁷ mbar oder niedriger erreicht hat, des Herausnehmens (11) der Gettervorrichtung aus der Kammer mit Hilfe der automatischen Substrathandhabungsausrüstungen und -abläufe, die für das Bewegen der Substrate während der Fertigungsschritte verwendet sind.

10. Verfahren nach Anspruch 6, wobei nach dem Erreichen eines Druckes von 10⁻⁷ mbar oder niedriger, die Gettervorrichtung aus der Kammer (13) erst herausgenommen wird, nachdem die Schritte durchgeführt sind, die der Aufdampfung dünner Schichten (12) vorausgehen.

11. Verfahren nach Anspruch 10, wobei das Beschichtungsverfahren für dünne Schichten ein PVD-Verfahren ist, und die vorbereitenden Schritte den Schritt der Reinigung eines Targets umfassen.

## Revendications

1. Procédé pour augmenter le rendement de processus de formation de dépôt de fines couches sur un substrat, comprenant de mettre en contact un dispositif de dégazage dans une forme activée avec l'atmosphère de travail à l'intérieur d'une chambre de traitement lorsque la somme des pressions partielles des gaz réactifs dans la chambre est inférieure à environ 10⁻³ millibar, et lorsque aucun substrat de production effective est en cours de traitement, en utilisant des équipements de manipulation de substrat automatisés et des procédures utilisées dans les étapes de fabrication au moins pour retirer le dispositif de dégazage de la chambre de traitement tout en maintenant ce dernier sous vide ou à une pression requise pour ledit processus de formation de dépôt.

2. Procédé selon la revendication 1, dans lequel le dégazeur est exposé à l'atmosphère de la chambre de traitement lorsque la pression totale dans ladite chambre est supérieure à 10⁻³ millibar et l'atmosphère comprend principalement des gaz rares.

3. Procédé selon la revendication 2, comprenant l'étape de :
- démarrer l'évacuation d'une chambre de traitement ;
- lorsque la pression a atteint une valeur d'environ 10⁻³ ou moins, introduire dans la chambre un dispositif de dégazage préactivé ou, en variante, activer thermiquement un dispositif de dégazage préalablement introduit dans la chambre ;
- purger la chambre avec le même gaz rare que celui qui sera utilisé en tant qu'atmosphère de traitement ;
- lorsque le niveau de contaminants dans l'atmosphère de la chambre est inférieur à une valeur donnée, démarrer les procédures de formation de dépôt.

4. Procédé selon la revendication 1, dans lequel le dispositif de dégazage est réintroduit dans la chambre de traitement et amené à remplir sa fonction de dégazage à des moments fixes pendant les opérations de traitement.

5. Procédé selon la revendication 4, dans lequel un dispositif de dégazage est réintroduit dans la chambre de traitement après que tous les substrats dans une boîte ont été traités et avant de démarrer le traitement des substrats d'une nouvelle boite.

6. Procédé selon la revendication 1, comprenant les étapes de :
- introduire un dispositif de dégazage dans la chambre de traitement (2 ; 6 ; 8) après son ouverture, avant ou pendant son évacuation (1 ; 5 ; 9), tout en opérant de telle façon que le dispositif de dégazage est présent dans une forme activée dans la chambre seulement lorsque la pression à l'intérieur a atteint des valeurs de 10⁻³ millibar ou moins ;
- continuer l'évacuation de ladite chambre, tout en maintenant à l'intérieur le dispositif de dégazage activé ;
- lorsque la pression dans ladite chambre a atteint une valeur de 10⁻⁷ millibar ou moins, retirer le dispositif de dégazage de ladite chambre (4 ; 7 ; 11) en utilisant les équipements de manipulation de substrat automatisés et des procédures utilisées dans les étapes de fabrication.

7. Procédé selon la revendication 6, comprenant les étapes de :
- démarrer l'évacuation (1) de la chambre de traitement ;
- après avoir atteint une valeur de pression dans ladite chambre de l'ordre de 10⁻³ millibar au moins, introduire (2) un dispositif de dégazage dans une forme non active au moyen des équipements de manipulation de substrat automatisés et de procédures utilisées pendant les étapes de fabrication ;
- activer (3) le dispositif de dégazage dans ladite chambre au moyen des équipements et des procédures comme utilisés pour chauffer les substrats pendant les étapes de fabrication ;
- lorsque la pression dans ladite chambre a atteint une valeur de 10⁻⁷ millibar ou moins, retirer (4) le dispositif de dégazage de la chambre au moyen des équipements de manipulation de substrat automatisés et des procédures utilisées pour déplacer les substrats pendant les étapes de fabrication.

8. Procédé selon la revendication 6, comprenant les étapes de :
- démarrer d'évacuation (5) de la chambre de traitement ;
- après avoir atteint dans la chambre une valeur de pression de 10⁻³ millibar au moins, introduire dans ladite chambre (6) un dispositif de dégazage, préactivé dans une autre chambre du système, au moyen des équipements de manipulation de substrat automatisés et de procédures utilisées pour déplacer les substrats pendant les étapes de fabrication ;
- lorsque la pression dans ladite chambre a atteint une valeur de 10⁻⁷ millibar ou moins, retirer (7) le dispositif de dégazage de la chambre au moyen des équipements de manipulation de substrat automatisés et de procédures utilisées pour déplacer les substrats pendant les étapes de fabrication.

9. Procédé selon la revendication 6, comprenant les étapes de :
- introduire (8) dans la chambre de traitement un dispositif de dégazage dans une forme non activée ;
- démarrer l'évacuation (9) de ladite chambre ;
- après avoir atteint dans ladite chambre une valeur de pression de 10⁻³ millibar ou moins, activer thermiquement (10) le dispositif de dégazage à l'aide des moyens et procédures tels qu'utilisés pendant la fabrication pour chauffer les substrats ;
- lorsque la pression dans ladite chambre a atteint une valeur 10⁻⁷ millibar ou moins, retirer (11) le dispositif de dégazage de la chambre au moyen des équipements de manipulation de substrat automatisés et de procédures utilisées pour déplacer les substrats pendant les étapes de fabrication.

10. Procédé selon la revendication 6, dans lequel, après avoir atteint une pression de 10⁻⁷ millibar ou moins, le dispositif de dégazage est retiré de ladite chambre (13) seulement après la réalisation des étapes préliminaires à la formation de dépôt de fines couches (12).

11. Procédé selon la revendication 10, dans lequel le processus de formation de dépôt pour de fines couches est du type PVD et lesdites étapes préliminaires comprennent l'étape de nettoyer une cible.
